Europäisches Patentamt

European Patent Office

Office européen des brevets

(19)

(11) Publication number: **0 262 397**

**A2**

(12) # EUROPEAN PATENT APPLICATION

(21) Application number: **87112424.4**

(22) Date of filing: **26.08.87**

(51) Int. Cl.4: **G06F 15/60**

(30) Priority: **12.09.86 US 907303**

(43) Date of publication of application:
**06.04.88 Bulletin 88/14**

(84) Designated Contracting States:
**AT BE CH DE ES FR GB GR IT LI LU NL SE**

(71) Applicant: **DIGITAL EQUIPMENT CORPORATION**
**146 Main Street**
**Maynard, MA 01754(US)**

(72) Inventor: **Hooper, Donald F.**
**13 Thoreau Road**
**Northboro Massachusetts 01532(US)**
Inventor: **Kundu, Snehamay**
**84 Bergeron Road**
**Marlboro Massachusetts 01752(US)**

(74) Representative: **Patentanwälte Grünecker,**
**Kinkeldey, Stockmair & Partner**
**Maximilianstrasse 58**
**D-8000 München 22(DE)**

(54) **Procedure and data structure for synthesis and transformation of logic circuit designs.**

(57) A procedure is described for the synthesis and transformation of a logic circuit design, provided by the designers, into a database capable of being used to fabricate the actual circuit. The procedure involves the use of model instances which represent the use of circuit components. The original model instances can be associated with groups of rules that determine resulting configurations of generally different model instances or groups of model instances. The rules are tested and, in the presence of a 'true' result, a new model instance (or model instances) can replace one or more original model instances in the data base. The rules associated with a model type (or definition) are rules derived by a design model engineer and can include coupled model instances. The rules can be associated with model definitions, as well as model instances. The data structures associated with each model instance indicate the model interface as well as the model interface port and permit a path to followed in the circuit in either the forward or the reverse signal direction. The model instances reside within model definitions which reside with design data in hierarchical form. The rules controlling the synthesis and transformation of the circuit are contained in a separate hierarchy of data structures or knowledge structures to which reference can be made by design data structures.

| | |
|---|---|
| 21 | ENTER ABSTRACT COMPONENT DATA FROM LIBRARY INTO MODEL DEFINITION DATA STRUCTURES |
| 22 | ENTER TARGET TECHNOLOGY COMPONENT DATA FROM LIBRARY INTO MODEL DEFINITION DATA STRUCTURES |
| 23 | ENTER DESIGN DATA WITH CONNECTED INSTANCES OF THE ABSTRACT COMPONENTS |
| 24 | SET UP POINTERS FOR PATH TRAVERSAL AND POINTERS TO ASSOCIATED RULES |
| 25 | TEST ASSOCIATED RULES AND WHEN "TRUE", APPLY RULE RESULTS |
| 26 | REPEAT STEP 25 UNTIL CIRCUIT DESIGN IS STABILIZED |
| 27 | PREPARE CIRCUIT DESIGN IN FORMAT FOR USE WITH AN AUTOMATED FABRICATION SYSTEM |

FIGURE 2

# PROCEDURE AND DATA STRUCTURE FOR SYNTHESIS AND TRANSFORMATION OF LOGIC CIRCUIT DESIGNS

## BACKGROUND OF THE INVENTION

### 1. Field of the Invention

This invention relates generally to the design of data processing systems and similar structures, and more particularly to an automated technique for the design a logic structure in a manner similar to the technique used by a design engineer.

### 2. Description of the Related Art

The design of digital logic circuits may be considered as a map of nodes and arcs, wherein the nodes are functional in nature and the arcs are connective in nature. For example, the functionality of a node may be that of an adder element, the adder element providing output signal in response to input signals. The adder element may be technology independent which, in the present context means that the adder element has no physical characteristics associated therewith and therefore does not define a digital device. The technology independent adder element is functionally correct and has attributes, such as a shape, for use in drawings, simulation behavior, equivalent gate count, etc. If a digital device, with a defined technology, were available that exactly matched the behavior and the interface characteristics of the adder element, then the digital device could be substituted for the technology independent adder in the design of the circuit. This technique is used in the automated design of digital logic circuits of the prior art where the transformation from technology independent to technology dependent design is accomplished by the substitution of previously designed elements defined by a predetermined technology.

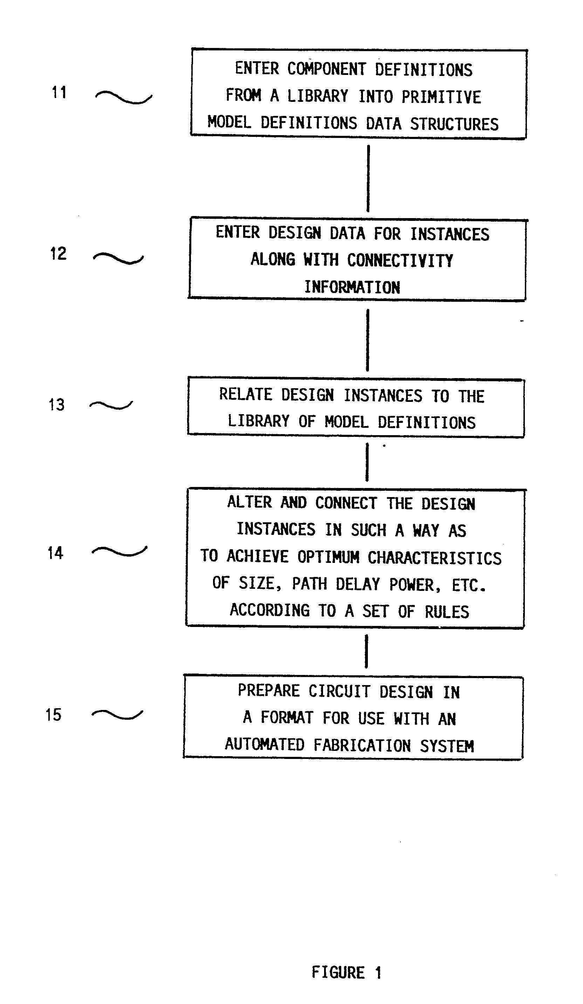

Referring next to Fig. 1, the procedure for synthesizing a logic circuit design according to the prior art is shown. Model definition data structures from a library of component definitions are entered into the data structures associated with the synthesis data base in step 11. In step 12, the information related to the instances of the circuit design, including the connectivity information, is entered in the data base. The instances of the circuit design are generally in a behavioral or functional form when entered in the synthesis data base. The synthesis procedure relates the instances of the circuit design to the model instances in step 13. In step 14, a set of rules for the synthesis procedure is applied to each of the model instances and the model instances are altered and connected in such a way as to maximize certain parameters such as size, path delay, power, etc. In step 15, the resulting circuit design is placed in a format that can control the automated fabrication of the circuit.

It will be clear that the procedure for synthesizing a circuit described in relation to Fig. 1 is severely limited. If a circuit designer were synthesizing the same functionally described circuit, a functional component might suggest a plurality of model instances. Some of the suggested model instances would be more suitable than others. In addition, upon application of rules to the design process, the circuit designer would not exercise all possible rules, but would use only the applicable rules. A circuit designer would typically transform the functional components into the most elemental model instance implementations and then attempt, by an iterative process, for example, to converge on an optimum design. The optimum design goal is typically a combination of physical component size along with physical data transmission time through the entire circuit. In addition, the circuit designer would investigate the neighbors of the each model instance to determine if additional improvement in the circuit design can be achieved by combining coupled model instances. The circuit designer would also investigate signal paths whether in the direction of the signal flow or in the opposite direction from the signal flow.

A need has therefore been felt for a data base structure and an accompanying synthesis procedure that achieves additional flexibility and performance by utilizing techniques more closely mimicking the techniques of a circuit design engineer.

## FEATURES OF THE INVENTION

It is an object of the present invention to provide an improved procedure for the design of digital logic circuits.

It is a feature of the present invention to provide two hierarchical information structures, a first hierarchical information structure for logic synthesis rules and a second hierarchical structure for logic design data.

## SUMMARY OF THE INVENTION

The aforementioned and other features are obtained, according to the present invention, by a synthesis procedure that applies a set of rules to each model instance of a circuit design, the applied rules being: a) rules related only to the particular model instance, b) rules related to the LIBRARY definition of that model instance, or c) global design rules. As a result of the application of the rules, one or more alternative model instances can be available to replace the current model instance (and possibly other physically associated model instances). In the event that more than one replacement model instance is available, a mechanism is provided for the selection of the replacement model instance. Because model instances of the circuit design resulting from the application of the rules have been changed, the rules must be reapplied to the new model instances. This process is repeated until the circuit design is stabilized, i.e. until no rules return a 'true' value when tested. The structure of the files is implemented to support the synthesis procedure of the present invention. The data relating to the design of the circuits is placed in one hierarchy while the data relating to rules is placed in a separate hierarchy. The design data includes pointers relating design data to rule data. In addition, the design data relating to model instances includes explicit interface and interface port information as well file constructs that permit a path through the circuit to be followed in any signal direction.

These and other features of the present invention will be understood upon reading of the following description along with the drawings.

## BRIEF DESCRIPTION OF THE DRAWINGS

Figure 1 is a flow diagram of the process for automatic synthesis of logic circuits according to the prior art.

Figure 2 is a flow diagram of the process for automatic synthesis of logic circuits according to the present invention.

Figure 3 is an overall diagram of the architecture for data structures of logic design and logic synthesis rules.

Figure 4 is a detailed illustration of the hierarchical relationship of the objects of the design model as it is transferred between external software mechanisms and this system.

Figure 5 is a detailed illustration of the objects of the Figure 2 design model as it is stored within this system.

## DESCRIPTION OF THE PREFERRED EMBODIMENT

### 1. Detailed Description of the Figures

Fig. 1 has been previously described with respect to the related art.

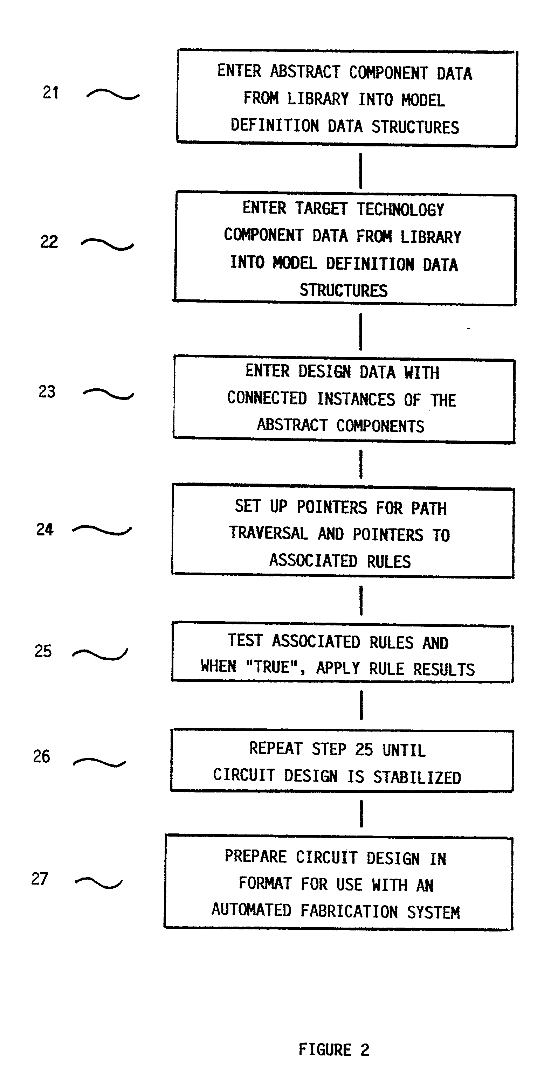

Referring next to Fig. 2, the synthesis procedure of the present invention is shown. In step 21, abstract component data from a library of such data is entered into model definition data structures of the synthesis procedure. In step 22, component data from the LIBRARY relating to the target technology is entered into model definition data structures of the synthesis procedure. The circuit design data with the connected instances described in terms of abstract components is entered into the synthesis procedure in step 23. In step 24, the synthesis procedure provides two sets of pointers. The first set of pointers permits the synthesis procedure to follow any arbitrary path through the design circuit. The second set of pointers couples rules with associated data base structures. In step 25, the associated rules are tested for each model instance and when the test provides a 'true' result, the consequences of the rule is implemented. In the preferred embodiment, each rule has an antecedent portion and a consequence portion. The antecedent portion includes a test algorithm, and the consequence portion provides the information required to implement a result of the test. Because the rules are applied to model instances in a sequential manner, and because in the preferred embodiment the test procedures can involve neighboring instances that are changed as a result of a test applied to that instance, the process is repeated until the circuit design has stabilized. In step 27, the final version of the circuit design is placed in a format suitable for use in an automated circuit fabrication system.

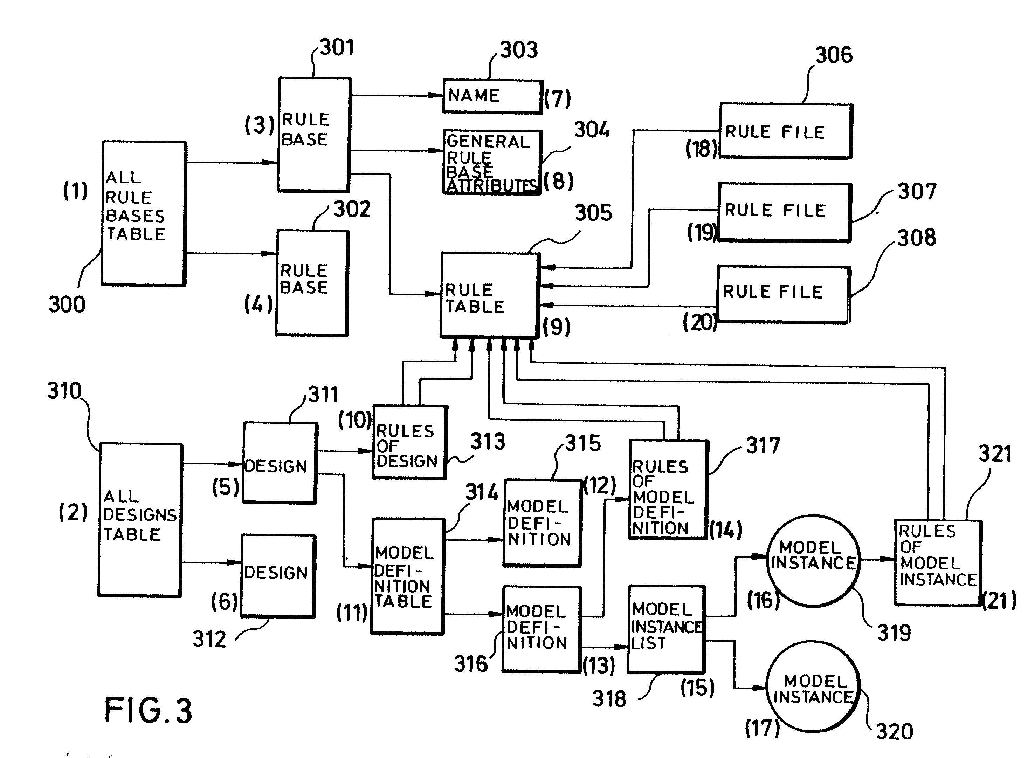

Referring now to Fig. 3, the architectural organization for the storage of the logic synthesis rules and the logic design rules are shown. Two storage hierarchies are available, one representing rule information and the second representing digital design information. These information hierarchies interact when pointers are established, relating the design objects to specific groups of rules. A rule file 306 through 308 is collection rules arbitrarily organized by the creator of the file. Several rule files can be transferred to a rule table 305. The rule table 305 is a lookup table that is indexed by the name of the rules stored therein. The rule table 305 is an attribute of a rule base 301 that has, in addition to the rules stored in rule table 305, a name 303 and other attributes 304 of the rule base. Any number of rule bases 301 through 302 are contained in the table of all of the rule bases 300.

The all rule bases table 300 is a lookup table indexed by the name of the rule base. The all rule base table 300 is the top of the rule information hierarchy. The logic design data is partitioned into blocks, called model definitions 315 through 316. Any number of model definitions can be stored in the model definition table, a lookup table indexed by the model name. A model definition can contain a model instance list 318 that includes model instances 319 and 320 that can include model instances of other model definitions. For any functional part type or structural body of a given name, only one model definition can exist. However, any functional part type or structural body can have 0 or more model instances. The attributes of the model definition are common to all of the instances associated therewith and, therefore need to be stored only with the model definition. The attributes of the model instances, such as timing parameters and simulation to each model consequently must be stored with the associated instance. Those model definitions with no model instances or for which a "LIBRARY" attribute is specified are considered primitive model definitions and are stored in table 315. The model definition table 314 is stored in a design table 312, the design table being capable of possessing other attributes. Any number of designs 311 through 312 can be contained in the all designs table 310.

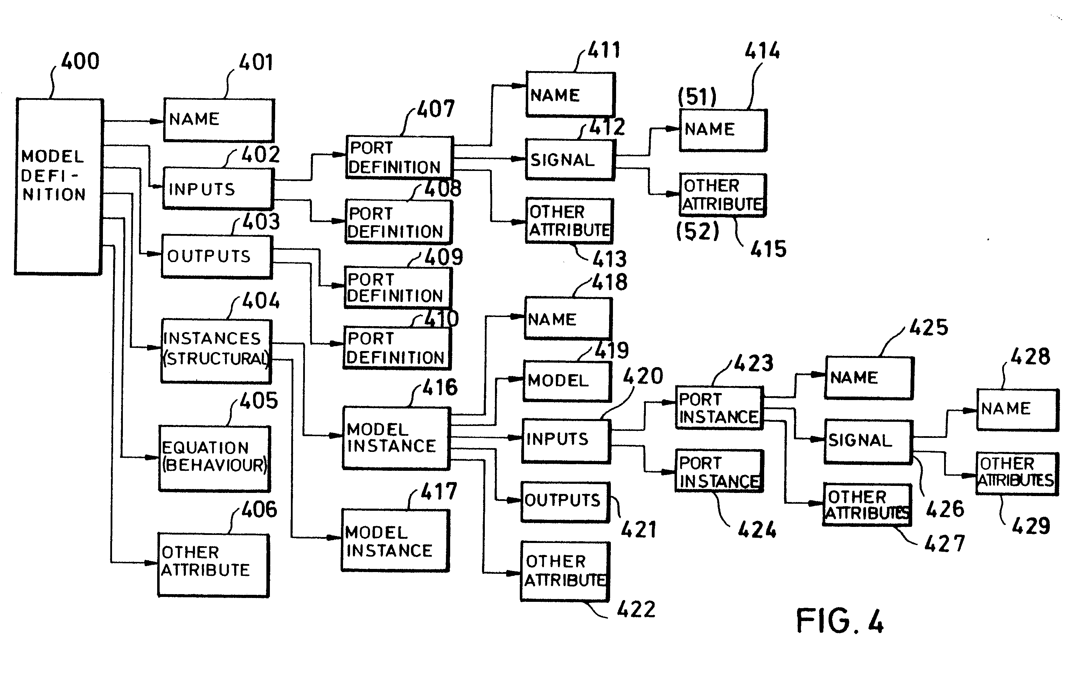

Referring to Fig. 4, the interface form of the model definition is shown. Each model definition has a model 401, an interface definition comprising input signals 402 and output signals 403 and other attributes 406. Each model definition can have a - schematic, structural or data flow form in which case the model definition would contain instances 404. Furthermore, a model definition can also have a functional form or a behavior form 405. The interface input signals are port definitions 407 and 408 and the interface output signals are also port definitions 409 and 410. Other types of interface signals such as bi-directional signals. Port definitions have a name 411, a signal 412, and other attributes 413. The signal of a port definition has a name 414 and other attributes 415. The model instances 404 can have a plurality of individual model instances 416 and 417 included therein. Each model instance 416 and 417 has a unique name 418, a name of its model definition 419, input and output interface instances 420 and 421 and other attributes 422. The interface instances 420 and 421 consist of port instances 423 and 424, while each port instance has a name 425, signals 426 and other attributes 427. Each signal has a name 428 and other attributes 429.

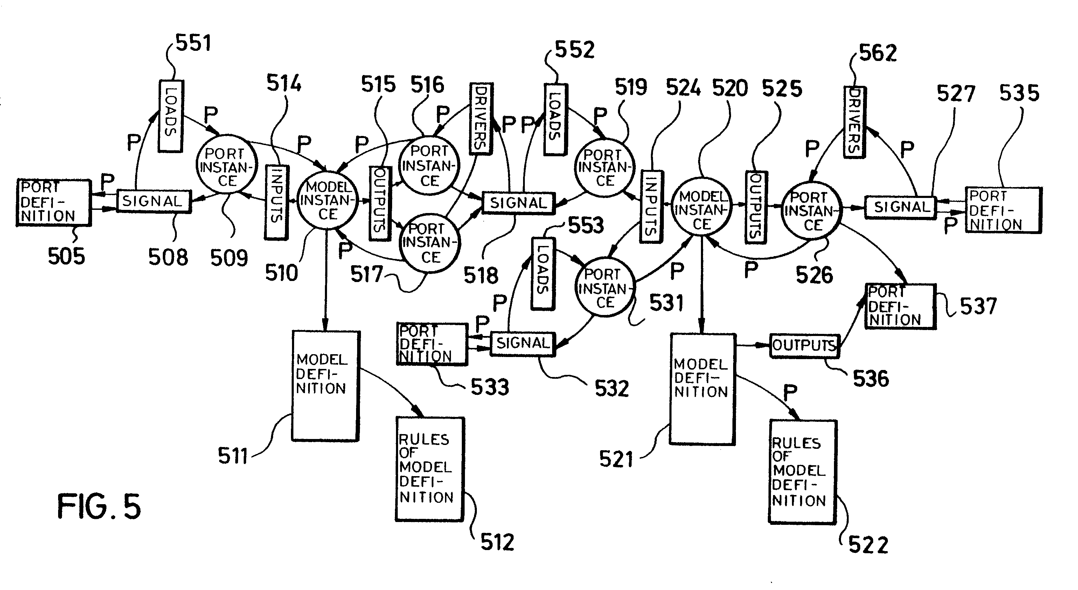

Referring next to Fig. 5, the connectivity of the components of the logic design tables is illustrated. The model instances and model definitions represent operational elements or functional blocks. The port instances and port definitions represent pins or interfaces of the operational elements or functional blocks. Signals represent the wires or connections between the pins or interfaces. In Fig. 5, two model instances 510 and 520 are shown. Each model instances has a pointer associated therewith that points to model definitions 511 and 521 respectively. The model definitions 511 and 521 have pointers associated therewith that point to rules of model definitions 512 and 522 respectively. The pointer can be followed from the port definition 505 to the signal 508 to the loads (i.e., intermediate pointer locations) 551 to port instance 509 to model instance 510 to outputs 515 to port instances 516 and 517 to signal 518 to loads 552 to port instance 519 to model instance 520 to outputs 525 to port instance 526 to signal 527 to port definition 535. Moreover, according to the present invention, the pointers permit the design to be followed from the final output definition 535 to the initial port definition 505 in the following manner: from port definition 535 to signal 527 to drivers 562 to port instance 526 to model instance 520 to inputs 524 to port instance 531 to signal 532 to port definition 533. All port instances 526 point to the port definitions 537 which are defined in the model definition 521 of the associated model instance 520.

## 2. Operation of the Preferred Embodiment

The synthesis procedure of the present invention involves several features not found in synthesis procedures of the related art. The model instance files are constructed in such a manner that the rules applied to the model instance during the synthesis procedure relate only to the particular model instance or to the definition of that model instance. A small subset of rules remain which relate to the design as a whole. In addition, the set of rules related to the model instance can involve a plurality of possible replacement model instances. Furthermore, the files related to the model instance and circuit design to be synthesized permit the rules to follow data structure and signal paths through the circuit design in any direction. This capability can be important, for example, in following critical paths through the circuit. Finally, the synthesis procedure can involve the replacement of one or more model instances with one or more model instances. Such a replacement can result in a requirement for further synthesis activity. The synthesis procedure of the present invention is adapted for an iterative process.

Referring once again to Fig. 3, the system is initialized by creating the rules bases and the primitive model definitions. The pointers 'P' (cf. Fig. 3 and Fig. 5) are then installed through a pointification process. Rules may identify a relationship of a model definition by naming the model definition. Rules which do not name a model definition, if not associated with a model instance are global design rules. The collection of rules for each model definition 317 (Fig. 3) are found in the rule table of each rule base. Pointers are established to point to the collection of rules and to the rule table 305. The rules of model definitions are organized into subgroups indexed by rule base names. When a rule does not identify a relationship to an object, a pointer pointing to the rule is placed in the rules of current design.

After the rule bases and the model definitions have been entered, the entry form of the logic design map is entered into the model definition table 316. The entry includes the interface specification, the model instances and their connectivity, and other attributes. Any model instance may also refer to rules of model instances 321 to be applied only to that model instance. The related rule is found in the rule basis 305 and a pointer to the rule is established. The two hierarchies are interrelated by pointers from the logic design map to the rules of design, rules of model definitions and rules of model instances.

A model definition is entered by an external software mechanism and inserted into the internal data structures. The model definition is placed in the models definition table of the current design (i.e. Table 314 in Fig. 3). Pointers are added as shown in Fig. 5 and can be utilized as described above in conjunction with Fig. 3. Data structures with the internal references described above provide a system of accessible logic elements on which the logic synthesis rules can operate. The rules that embody design knowledge can number in the hundreds. A rule can have an antecedent activity and a consequent activity. Typically in rule-base driven software, the antecedent activity acts as a predicate to test the working data and should the predicate return a 'true' value, the consequent activity serves to change the working data. However, unlike previous rule-based software systems which store the working data in a non-hierarchical memory table, the data to be operated upon in the present invention is the hierarchical database itself. Also, unlike the previous rule-based design systems in which the entire rule set is scanned sequentially, in this system, the model instances are scanned in parallel and for each instance, only a small subset of rules associated with the type of model instance is scanned. As is characteristic of rule based systems, the consequences of several rules can return a 'true' verdict, and an arbitration rule mechanism used for conflict resolution, chooses the rule to be applied. In the present invention, the best set of rules for each model instance is chosen. Then, the set of chosen rules are tested and applied to their respective model instances. The priority is determined by the SIZEWIN field of the rules.

## Claims

1. A procedure for automatic synthesis of logic structures comprising the steps of:
   identifying and representing each component in a circuit design {file} with a {model instance} data structure in a hierarchical database associated with said procedure;
   applying a set of rules associated with each of said {model instances} data structures to said {model instances} component data structures and,
   when predetermined conditions are present upon application of said rules, replacing or otherwise altering said {model instance} component data structures in said circuit design {file with a new model instance} according to said set of rules.

2. The procedure for automatic synthesis of logic circuits of Claim 1 wherein said applying step includes applying rules associated with said component data structures.

3. The procedure for automatic synthesis of logic circuits of Claim 2 further including the step applying rules associated with a model definition data structure when no model instance data structure rules are relevant.

4. The procedure for automatic synthesis of logic circuits further comprising the step of applying rules related to design technology when no model definition rules are applicable.

5. The procedure for automatic circuit design synthesis of Claim 4 wherein said applying step is repeated until said circuit design no longer changes.

6. The procedure for automatic circuit design synthesis of Claim 5 further comprising the step of constructing includes rule data structures generated from one set of files, design data structures generated from a secon set of files and library data structures generated from a third set of files.

7. The procedure of automatic circuit design synthesis of Claim 6 further comprising the step of including in said design data structures a plurality of model instance data structures, wherein each of each of said model instances files data structures has a pointer to a related rule data structures in said first set of data structures, and wherein each model definition representing library data can point to related rule structures.

8. The procedure for automatic circuit design synthesis of Claim 7 further comprising the step of constructing said model instance data structures and said circuit design data structures to permit a circuit path to be analyzed by said rules in any circuit direction and to achieve access to all design and library files.

9. The procedure for automatic circuit design synthesis of Claim 6 further including the step of constructing said model instance data structures to include interface data and to include port interface data.

10. In a synthesis procedure for logic circuits, a data base structure comprising:

a rule base data structure; and

a hierarchy of design data structures, wherein each member in said design data structures is associated with related rules in said rule data base structure.

11. The synthesis procedure data base structure of claim 10 wherein said design data structure hierarchy includes model instance data structures, model definition data structures and design data structures.

12. The synthesis procedure data base structure {s} of Claim {8} 10 wherein each model instance of said circuit design can identify has a pointer structure identifying any other model instance coupled thereto.

13. The synthesis procedure data base structure of Claim 11 wherein each of said model instance data base structures, each of said model definition data base structures and each of said design data base structures have pointers identifying associated rule data structures.

11    ENTER COMPONENT DEFINITIONS
FROM A LIBRARY INTO PRIMITIVE
MODEL DEFINITIONS DATA STRUCTURES

12    ENTER DESIGN DATA FOR INSTANCES
ALONG WITH CONNECTIVITY
INFORMATION

13    RELATE DESIGN INSTANCES TO THE
LIBRARY OF MODEL DEFINITIONS

14    ALTER AND CONNECT THE DESIGN
INSTANCES IN SUCH A WAY AS
TO ACHIEVE OPTIMUM CHARACTERISTICS
OF SIZE, PATH DELAY POWER, ETC.
ACCORDING TO A SET OF RULES

15    PREPARE CIRCUIT DESIGN IN
A FORMAT FOR USE WITH AN
AUTOMATED FABRICATION SYSTEM

FIGURE 1

21 — ENTER ABSTRACT COMPONENT DATA FROM LIBRARY INTO MODEL DEFINITION DATA STRUCTURES

22 — ENTER TARGET TECHNOLOGY COMPONENT DATA FROM LIBRARY INTO MODEL DEFINITION DATA STRUCTURES

23 — ENTER DESIGN DATA WITH CONNECTED INSTANCES OF THE ABSTRACT COMPONENTS

24 — SET UP POINTERS FOR PATH TRAVERSAL AND POINTERS TO ASSOCIATED RULES

25 — TEST ASSOCIATED RULES AND WHEN "TRUE", APPLY RULE RESULTS

26 — REPEAT STEP 25 UNTIL CIRCUIT DESIGN IS STABILIZED

27 — PREPARE CIRCUIT DESIGN IN FORMAT FOR USE WITH AN AUTOMATED FABRICATION SYSTEM

FIGURE 2

FIG.3

FIG. 4

0 262 397

FIG.5

0 262 397